**Europäisches Patentamt**

**European Patent Office**

**Office européen des brevets**

(11) Publication number: **0 167 243**
**B1**

# EUROPEAN PATENT SPECIFICATION

(45) Date of publication of patent specification: **23.08.89**

(51) Int. Cl.⁴: **G 01 N 24/06, H 01 F 7/22**

(21) Application number: **85303259.7**

(22) Date of filing: **08.05.85**

(54) Magnetic structure.

(30) Priority: **06.07.84 US 628452**

(43) Date of publication of application:
**08.01.86 Bulletin 86/02**

(45) Publication of the grant of the patent:
**23.08.89 Bulletin 89/34**

(84) Designated Contracting States:
**DE FR GB NL**

(56) References cited:
**EP-A-0 138 270**
**EP-A-0 144 171**
**DE-A-2 146 071**

**ELECTRO MEDICA (SIEMENS), vol. 51, no. 2,
1983, pages 65-72, Erlangen, DE; H.
MORNEBURG: "Gesichtspunkte bei der
Standortsuche und Planung für ein Magnetom"**

(73) Proprietor: **THE BOARD OF TRUSTEES OF THE
LELAND STANFORD JUNIOR UNIVERSITY
Encina 105 Stanford University
Stanford California 94305 (US)**

(72) Inventor: **Smith, Todd Iversen
685 Wildwood Lane
Palo Alto California 94303 (US)**
Inventor: **McAshan, Michael Sanford
3003 Waverly Street
Palo Alto California 94306 (US)**
Inventor: **Fairbank, William Martin
141 East Floresta Way
Menlo Park California 94025 (US)**

(74) Representative: **Cross, Rupert Edward Blount
et al
BOULT, WADE & TENNANT 27 Furnival Street
London EC4A 1PQ (GB)**

**Description**

This invention relates generally to magnetic structures, and more particularly the invention relates to magnetic structures for use in nuclear magnetic resonance (NMR) applications and the like.

NMR, sometimes referred to as magnetic resonance imaging (MRI), is a new technology which can be used to produce two-dimensional slices of the human body on the video screen. The technology offers an advantage over the commercially available computed tomography (CT) scanners which require exposure of the patient to ionizing radiation. Further, NMR can be employed to observe many different types of atoms and identify the chemical environment of each atom.

NMR uses a strong magnetic field to line up atoms whose nuclei have an odd number of protons. A second RF magnetic field, usually applied at right angles to the first, is used to pump energy into these nuclei, flipping them over. When the applied magnetic field is removed, the nuclei flip back and give up the energy in the form of weak but detectable electromagnetic waves. These signals are used by a computer to produce images.

NMR images can be formed with protons in magnetic fields of only a few kilogauss. However, NMR information from other nuclei, such as fluorine and phosphorous requires fields of a few Tesla. Indeed, even with protons there are many advantages to using magnetic fields of one to two Tesla. On the other hand, strong magnetic fields outside of the viewing area can present a danger to humans not only from possible deleterious biological effects but also from ferromagnetic objects which are subject to powerful magnetic forces in the field gradient.

Standard practice has been to produce the necessary uniform fields with either end-corrected solenoids or with a number (typically four) of coils distributed along the axis of symmetry of the system. The field uniformity is determined by the geometry of the system and the relative currents in the various coils or windings, while the field magnitude is determined by the magnitude of the currents. In these systems, all of the different components produce magnetic fields in the same direction, and far from the windings the magnetic field necessarily looks as though it was produced by a dipole. The field thus decreases as the cube of the distance from the magnet.

Heretofore, shielding of the magnetic field outside the region of interest has been handled in two ways. Access to the region where the field is above a nominal five gauss limit can be restricted by various means, or the field can be contained through the use of ferromagnetic shielding. For a two Tesla whole body magnet the field drops to 5 gauss only at a distance of 30 or 40 feet from the magnet. Access to this region must be restricted from all sides, and from the top and bottom. The use of iron to shield the outside world from the magnet is difficult and expensive because of the amount of iron necessary. For a reasonably sized room the weight of the iron amounts to many tons. Further, in addition to the building structure having to be able to support the weight of the iron, the forces between the iron shielding and the magnet have to be carefully considered.

The use of a second magnetic field to offset a first magnetic field is heretofore known. See US—A—3493304, US—A—3671902, US—A—3466499. However, these applications are unrelated to NMR applications and do not encounter the constraints found in NMR applications. US—A—3493304 discloses a structure for generating a uniform magnetic field within a spherical volume by employing a single surface winding having contiguous turns over the spherical surface except at the axis of generation. Small access channels are provided at the vicinity of the axis. A shield winding is provided on a concentric spherical surface with the two windings connected in series and in magnetic opposition. US—A—3671902 discloses a shield for a single superconductive coil which comprises a plurality of conductive coils which surround the superconductive coil both laterally and longitudinally. US—A—3466499 discloses a shield for an elongate cylindrical conductor comprising a second, elongate cylindrical conductor coaxial with the first conductor. The second conductor accommodates a current sheet having a direction and magnitude to produce a field which squashes the field produced by the inner current sheet. None of these disclosures is relevant to NMR applications.

In EP—A—0144171 (priority; 11.11.83; publication: 12.06.85) there is disclosed an NMR magnetic structure including a first superconducting coil assembly for generating a first magnetic field, and a second superconducting coil assembly for generating a second magnetic field. The two coil assemblies are connected in series whereby corresponding components of the first and second magnetic fields are of substantially the same order of magnitude whereby a resultant uniform magnetic field is generated within a cylindrical working volume surrounded by the coil assemblies, while the second magnetic field opposes the first magnetic field externally of the structure.

In EP—A—0138270 (priority; 14.10.83; publication: 24.04.85) there is disclosed an NMR magnetic structure in which about a first superconducting coil assembly there is disposed a second superconducting coil assembly which is capable of generating a magnetic field such that the external stray field of the first coil assembly is compensated for. The coil assemblies surround a cylindrical working volume which can receive a patient.

According to this invention there is provided an NMR magnetic structure comprising an opening leading to a volume for receiving a patient; a first set of superconducting coils provided about said volume and energizable to establish a field with suppressed lower order derivatives of flux through said volume and a dipole with higher order magnetic moments outside of said first set of coils; and a second set of

2

superconducting coils provided about said first set of coils and energizable for producing a magnetic field which opposes said dipole of said first set of coils while not substantially affecting the uniformity of said field through said volume, characterised in that said first set of coils and said second set of coils are arranged on generally spheroidal surfaces about said opening, and in that said first and second sets of coils are configured and energized to suppress lower orders of derivatives of flux within said first and second sets of coils and to suppress corresponding multipole moments of the magnetic flux outside of said second set of coils, and to suppress multipole moments outside of the structure.

With structures in accordance with the present invention reduced external fields are realized while maintaining a uniformity of magnetic field in the NMR inspection area. The coil geometry is such that when the currents in the coils are set to eliminate various orders of derivatives of flux with respect to position in the center of the volume, corresponding multipole moments of the field outside of the coil region are simultaneously eliminated. A uniform field inside the coils corresponds to an external field which decreases as the cube of the distance from the coils (a dipole field), while in general a component of the field in the center which varies as the nth power of the position at the center corresponds to a field which decreases as the $(n+3)$ power of the distance from the center. Thus, when the currents in the first plurality of coils are set to produce a very uniform field in the center, the external field is that of a very pure dipole.

The properties of the second set of coils are similar to the first set in that there is correspondence between the derivatives of the field produced by the second set in their center and the external multipoles produced by this set. The second set of coils may differ in number and angular placement from the first set of coils. Accordingly, the second set of coils can be used to produce a very uniform field in their center and a very pure dipole outside their volume.

The dipole field produced by the second set of coils is adjusted to cancel or to reduce substantially the dipole field produced by the first set of coils. The remaining external fields are greatly reduced in magnitude and decrease with a very high power of the distance from the coils. The total magnetic field within the first set of coils remains highly homogeneous, and is only slightly reduced by the field of the second set of coils.

By providing effectively shielding as in a magnetic structure in accordance with the invention, the volume to which access must be restricted is reduced enormously as is the amount and weight of iron required to shield the remaining field, if desired. Moreover, the uniform magnetic field through the volume is enhanced by eliminating the lower order derivatives of flux.

This invention will now be described by way of example with reference to the drawings, in which:—

Figure 1 is a perspective view of a magnetic structure in accordance with the invention;

Figure 2 is a section view of the magnetic structure of Figure 1 taken along the line 2—2;

Figure 3 illustrates the magnetic shielding available with the magnetic structure of Figure 2;

Figure 4 illustrates the external field of a structure in accordance with the invention and the external field of a conventional magnet; and

Figure 5 is a section view of sets of coils showing coil locations for different coil cross-sections.

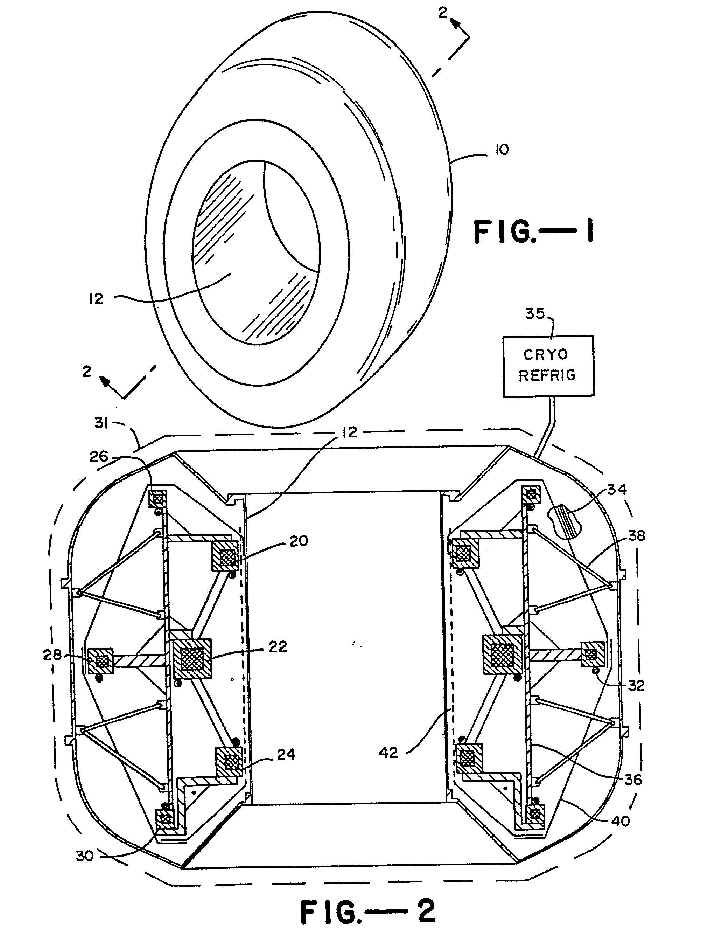

Referring now to the drawing, Figure 1 is a perspective view of the outside of a magnetic structure for use in NMR imaging. Conventionally, the magnetic structure comprises a generally spherical vacuum housing 10 having a cylindrical opening 12 therethrough for receiving a patient and couch for imaging purposes. As above described, the magnet must be of sufficient strength to generate a uniform magnetic field within the opening 12 of the order of one to two Tesla. The magnetic structure appears as a dipole outside of the housing, and because of the field strength dangerously high magnetic fields exist up to distances many feet from the housing 10. Shielding required to make the magnetic structure useful in an ordinary hospital space, for example, would be prohibitive in weight.

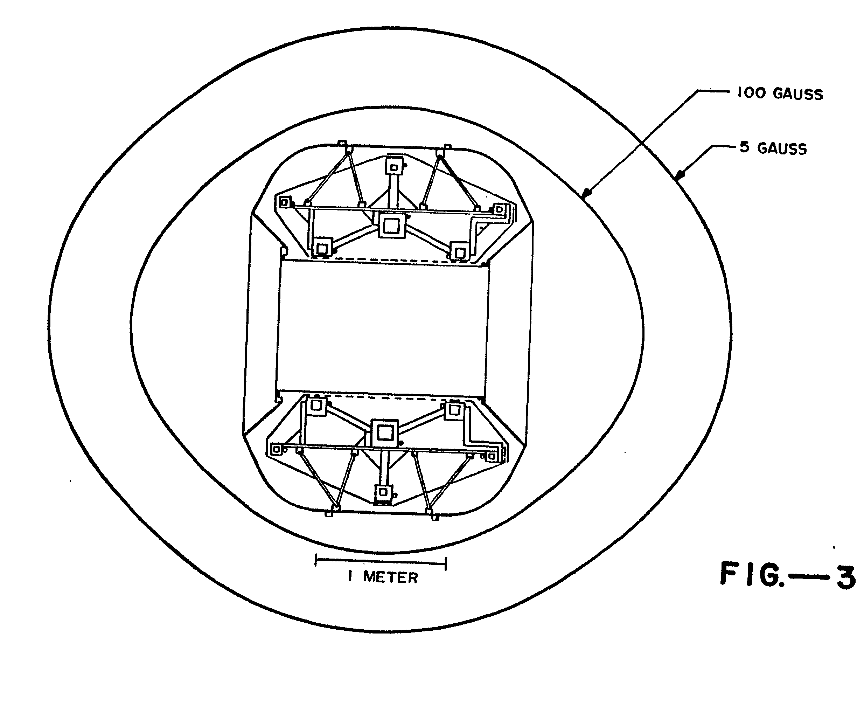

Figure 2 is a section view of the magnetic structure of Figure 1 taken along the line 2—2. A first coils means comprising a first set of superconducting coils 20, 22, and 24 surround the cylindrical opening 12 and define a first strong and uniform magnetic field necessary within the cylindrical opening 12, the coils being supported by suitable supports as shown. Positioned about the first set of coils 20—24 and spaced therefrom is a second set of superconducting coils 26, 28 and 30. The second set of coils is energised by a current having a direction to generate a second magnetic field in opposition to the magnetic field generated by the first set of coils 20—24. The magnitude of the second magnetic field is established to cancel the dipole moment of the first magnetic field outside of the magnetic structure. However, the second field is substantially less than the first magnetic field within the opening 12, and the field within the opening remains uniform. The magnitude of the field within the opening is established by the currents through the two sets of coils. To further enhance the magnetic shielding a ferromagnetic shield 31 can be provided around the magnetic structure.

This arrangement of coil sets is the so-called Maxwell three-coil configuration. The inner three coils are on a sphere of 80 cm radius and the outer three are on a sphere of 125 cm radius. The current in the outer coils is adjusted to exactly cancel the external dipole (about 40% of the current in the inner coils) and the resultant central field is thereby reduced to about 74% of that produced by the inner coils alone. This central field varies as the sixth power and the external field as the inverse ninth power of the normalized radius. The following table illustrates the central field uniformity:

## Central field uniformity

| Field uniformity | Diameter of volume |
| --- | --- |
| $1 \times 10^{-7}$ | 9 cm |
| $1 \times 10^{-6}$ | 13 cm |
| $1 \times 10^{-5}$ | 20 cm |
| $1 \times 10^{-4}$ | 29 cm |

The structure of Figure 2 uses forced-low cooling from a dedicated refrigerator 35 that is part of the magnet installation. This refrigerator provides a stream of saturated liquid helium which flows in tubes or channels 32 in thermal contact with the superconducting windings. These channels may be integrated into the winding itself if necessary, and they may be run to areas of high local heat leak, such as support points. After passing through the magnet, the stream still saturated, returns to the refrigerator. The refrigerator also provides a flow of helium gas at 20 K to cool shielding that intercepts the thermal radiation and conductions from room temperature. The heat load on this shielding is controlled by means of multi-layer insulation shown at 34. However, this insulation does not have to be of the highest performance. The shield cooling gas also returns to the refrigerator, near 60 K. The structure is within vacuum vessel 34. Structure 36 supports the coils along with fiberglass reinforced straps 38, thermal radiation shield 40 is positioned between the coils and the vessel 34. A non-conducting bore tube and coil-foil thermal radiation shield 42 is provided near the central opening of the magnet structure. The closed-cycle, a forced-flow cryogenic system allows enormous simplification of the magnet construction over systems employing pool-boiling.

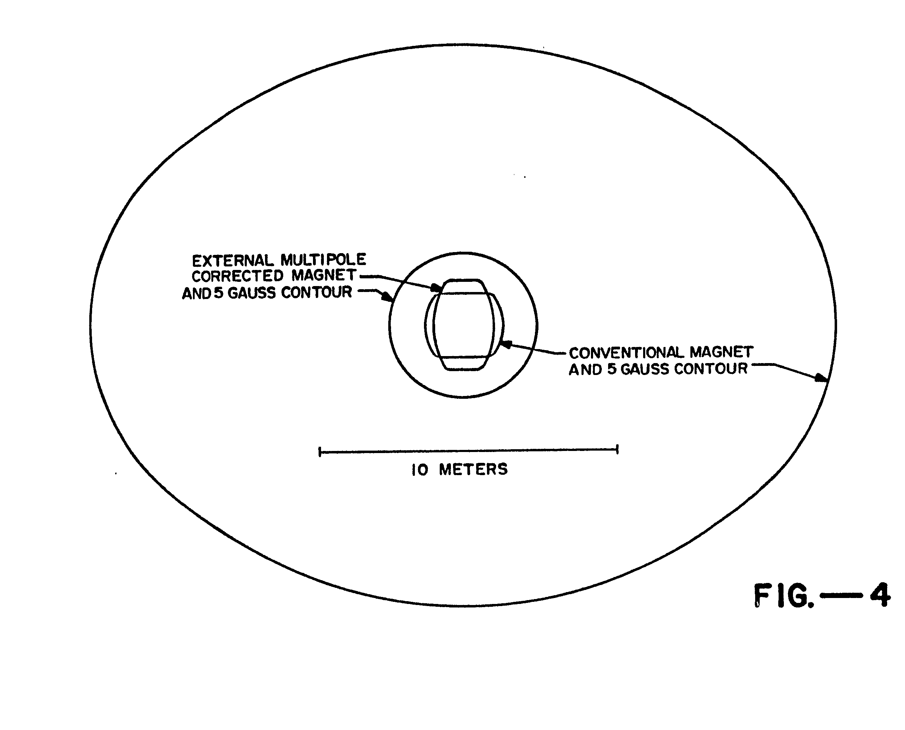

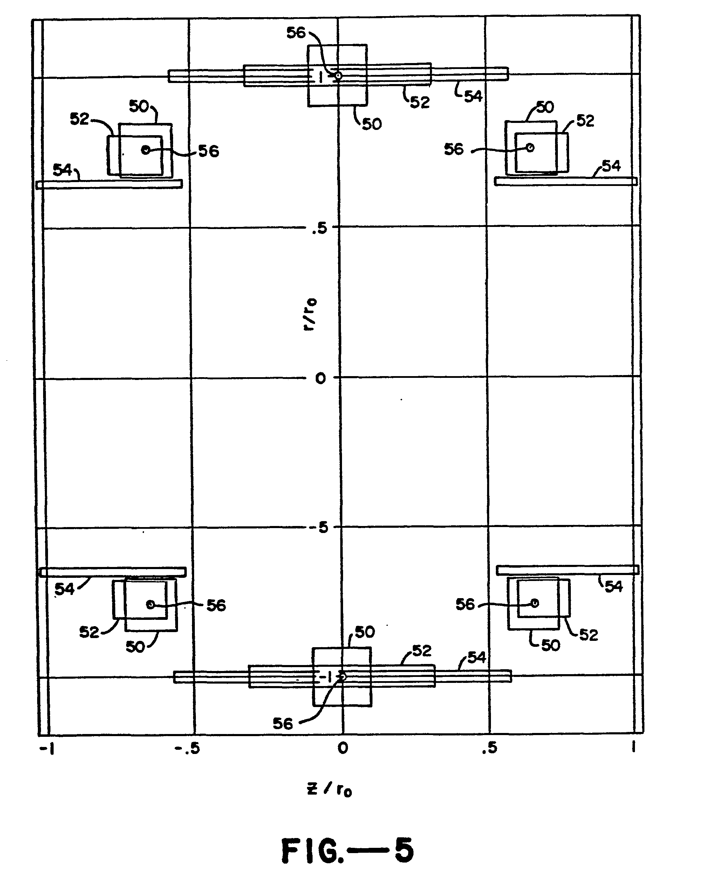

Figure 3 illustrates the total magnetic field outside of the magnetic structure in the presence of the opposing magnetic field. The magnetic field in the central region is 1.5 Tesla. From this drawing it is seen that the five gauss contour is confined to a distance within approximately 1—2 meters of the magnetic structure. Thus, the magnetic structure can be used with NMR imaging equipment in a typical hospital laboratory room. Figure 4 compares the external field of the present structure with that of a conventional NMR imaging magnet. The internal field produced by either magnet is 1.5 Tesla.

The invention can be mathematically described with long solenoids although it must be emphasized that the use of solenoids does not offer the advantage of other systems to be discussed shortly. The field on the axis of a solenoid can be written as

$$B(z) = B_0 \frac{\sqrt{a^2 + L^2/4}}{L} \left[ \frac{L/2 - z}{\sqrt{(L/2 - z)^2 + a^2}} + \frac{L/2 + z}{\sqrt{(L/2 + z)^2 + a^2}} \right]$$

where z is the distance along the axis from the center of the solenoid, L is the length of the solenoid, a is its radius, and $B_0$ is the field at the center. It is straightforward to expand this expression in powers of $1/z$ to show that when z is large compared with L and a,

$$B(z) = B_0 \frac{\sqrt{a^2 + L^2/4}}{L} \left( \frac{a^2 L}{z^3} \right) + 0(1/z^3).$$

Now, suppose we have two concentric solenoids, forming a symmetric system. For simplicity assume that the length of the solenoids are the same, and assume that they are long compared with their radii so that $(\approx a^2 + L^2/4)/L$  L/2.

Then if we adjust the currents in the solenoids so that

$$B_{01} a_1^2 + B_{02} a_2^2 = 0,$$

we will have a system with no dipole field and the field at large z will fall off as $1/z^5$. The field in the center of the system will be

$$B(0) = B_{0_1} \left( 1 - \left( \frac{a_1}{a_2} \right)^2 \right).$$

The penalty which has to be paid for the reduced external field is an increase in the current in the coils in order to produce the same central fields as without the cancelling coils. With normal conducting coils this penalty may be quite severe, but with a superconducting system the gains are worth the increased winding weight and complexity.

Systems of coils located on the surface of spherical shells are even more interesting than the solenoidal example above. It is well known that the magnetic field produced by current flowing on a

4

spherical shell is absolutely uniform inside the shell and is a perfect dipole outside the shell, if the current density varies as $\sin\alpha$, where $\alpha$ is the angle between the internal field and the vector to the shell.

The fact that the external field is a perfect dipole guarantees that the field outside the larger of the two concentric spherical shells is identically zero, as long as the ratio of the current densities on the two shells is adjusted to cancel the dipoles. The field inside the smaller shell will be somewhat reduced, but it will still be absolutely uniform. To be specific, the 'z' component of the field inside a shell is proportional to $I/a$, while the outside is proportional to $I/a\,(a/z)^3$. If there are two shells, then

$$I_1 a_1^2 + I_2 a_2^2 = 0$$

sets the external field to zero. The field inside the smaller shell is then

$$B_I = B_1 \left( 1 \left( -\frac{a_1}{a_2} \right) \right)^3$$

where $B_1$ is the field produced by the inner shell alone.

While the field produced by the two concentric shells is ideal from some point of view, the configuration usually won't be very practical. The problem, of course, is access to the uniform field region. While access could be attained by arranging for the shells to be opened temporarily along a constant planes, fields produced by discrete planar coils providing inherent accessibility should be superior for many purposes.

To this end, consider a single spherical shell with a finite number of coils, wound at discrete angles $\alpha_i$ on the surface of the shell. This, of course, sets the planes of the various coils parallel to each other. Considering the direction perpendicular to these planes as the 'z' axis, it can be shown that the magnetic field generated by the 'i'th coil along the axis is given by:

$$B_{z_i} = \frac{\mu I_i \sin\alpha_i}{2a} \sum_{n=1}^{\infty} \left( \frac{z}{a} \right)^{n-1} P_n^1(\cos\alpha_i) \quad z \leq a$$

or

$$B_{z_i} = \frac{\mu I_i \sin\alpha_i}{2a} \sum_{n=1}^{\infty} \left( \frac{a}{z} \right)^{n+2} P_n^1(\cos\alpha_i) \quad z \geq a.$$

In these equations, $I_i$, and $\alpha_i$ refer to the current and the coordinate of the ith coil located on the spherical shell of radius a. $P_n^1(x)$ is the associated Legendre polynominal in standard notation, and z is the distance along the axis from the center of the sphere. Note that the diameter of the coil is given by $a \sin\alpha_i$.

The total field produced by a set of coils can be obtained by adding the contribution of the individual coils as given in equations 7 and 8. It can now be seen that if the $\alpha_i$ and $I_i$ of a set of coils is chosen so that the coefficient of any of the $z^{m-1}$ term is zero for the internal field, then the coefficient of the $z^{-(m+2)}$ term will also be zero.

To produce the most uniform field inside the sphere, the obvious procedure is to choose the $\alpha_i$ and $I_i$ to eliminate as many of the $z^{m-1}$ terms (for $m \neq 1$) as possible. (Depending on whether the desire is for maximally uniform field at $z=0$, or for maximum average uniformity over some specific region, or some other particular requirement, the details of the procedure will differ but the idea will not.) The presence of the $m=1$ term will give a uniform field inside and a dipole outside. Every $z^{m-1}$ term eliminated inside will automatically eliminate a $z^{-(m+2)}$ multipole term outside. Thus as the internal field becomes more uniform, the external field becomes a more perfect dipole.

As examples, consider a two coil system, and a three coil system. If the coils are placed and excited symmetrically about the $z=0$ plane ($\alpha=\pi/2$) then half the terms in the field expansion will automatically vanish. This symmetry will be assumed. For the two coil system we can write:

$$B_z = \frac{\mu_0 I}{a} \sin\alpha \sum_{n \text{ odd}} \left( \frac{z}{a} \right)^{n-1} P_n^1(\cos\alpha) \quad z \leq a.$$

Since $P_3^1(\cos\alpha) = 3/2 \sin\alpha\,(5\cos^2\alpha - 1)$, if $\alpha$ is chosen so that $5\cos^2\alpha = 1$ then the $z^2$ term vanishes. The fields (on axis) inside and outside the sphere can then be written:

EP 0 167 243 B1

$$B_z = \frac{4}{5} \frac{\mu_0 I}{a} \left(1 + \sqrt{5/4} \left(\frac{z}{a}\right)^4 P_5^1 \left(\frac{1}{\sqrt{5}}\right) + 0(z^6)\right) \quad z < a$$

$$B_z = \frac{4}{5} \frac{\mu_0 I}{a} \left(\frac{a}{z}\right)^3 \left(1 + \sqrt{5/4} \left(\frac{a}{z}\right)^4 P_5^1 \left(\frac{1}{\sqrt{5}}\right) + 0(z^{-6})\right) \quad z > a$$

As the radius of each coil is given by $a \sin \alpha_2$ and the coil separation is given by $2a \cos \alpha$, the choice $\cos^2 \alpha = 1/5$ is just that for the coil radius to be the same as the separation. This geometry is familiar as the Helmholtz configuration.

For the three-coil system we write:

$$B_z = \frac{\mu_0}{2a} \sum_{n \text{ odd}} \left(\frac{z}{a}\right)^{n-1} (I_0 \sin\alpha_0 P_n^1(\cos\alpha_0) + 2 I_1 \sin\alpha_1 P_n^1(\cos\alpha_1))$$

From the symmetry condition discussed earlier, $\alpha_0 = \pi 12$. We now choose $I_0/I_1$ and $\alpha_1$ so that both the $z^2$ and the $z^4$ term vanish. The two conditions can be written ($P_5^1 (\cos\alpha) = 15/8 \sin\alpha (21 \cos^4\alpha - 14 \cos^2\alpha + 1)$) as

$$-\frac{3}{2} I_0 + 3 I_1 \sin^2\alpha_1 (5 \cos^2\alpha_1 - 1) = 0$$

$$\frac{15}{8} I_0 + \frac{15}{4} I_1 \sin^2\alpha_1 (21 \cos^4\alpha_1 - 14 \cos^2\alpha_1 + 1) = 0.$$

These are satisfied by $\cos^2\alpha_1 = 3/7$, $I_0 = 64/49 \, T_1$. With these choices, $B_z$ can be written as:

$$B_z = \frac{15}{16} \frac{\mu_0 I_0}{a} \left[1 + \frac{8}{15} \left(\frac{z}{a}\right)^6 \left(P_7^1(0) + \frac{7}{8} P_7(\cos\alpha_1)/\sin\alpha_1\right) + 0(z^8)\right] \quad z < a$$

$$B_z = \frac{15}{16} \frac{\mu_0 I_0}{a} \left(\frac{a}{z}\right)^3 \left[1 + \frac{8}{15} \left(\frac{a}{z}\right)^6 \left(P_7(0) + \frac{7}{8} P_7^1(\cos\alpha_1)/\sin\alpha_1\right) + 0(z^{-8})\right] \quad z > a$$

This three coil configuration, not as well known as the Helmholtz coils, is called the Maxwell geometry.

The purpose of these examples which are well known is to illustrate that the multipole components (other than the dipole) outside the sphere are reduced to zero at the same time that the spatial derivatives of B are reduced to zero inside the sphere.

In the usual coil arrangement the fact that the dipole field outside is becoming more and more perfect is rather irrelevant. The dipole field is large and carries a substantial amount of flux. The small perturbations in the dipole field at modes values of (a/z) are completely irrelevant to the field and shielding problem.

However, if two sets of coil geometries are used, but with different shell radii a, then the picture changes substantially. As discussed earlier, one set of coils can be used to cancel the dipole field of the other. In this case, the *only* fields outside the larger sphere are the higher order multipoles which decrease very rapidly as z increases.

As an illustration, consider two sets of the three coil geometry. Let the smaller set carry current $I_0$ in its center coil and have a radius of $a_0$. Let the larger coil set carry current $I_1$ and have radius $a_1$. The coils are concentric and coaxial, so the resulting field on axis can be written as:

$$B_z = \frac{15}{16} \mu_0 \frac{I_0}{a_0} \left[1 + \frac{I_1}{I_0} \left(\frac{a_0}{a_1}\right) - \frac{143}{70} \left(\frac{z}{a_0}\right)^6 \left(1 + \frac{I_1}{I_0} \left(\frac{a_0}{a_1}\right)^7\right) + 0(z^8)\right] \quad z < a$$

$$B_z = \frac{15}{16} \mu_0 \frac{I_0}{a_0} \left(\frac{a_0}{z}\right)^3 \left[\left(1 + \frac{I_1}{I_0} \left(\frac{a_1}{a_0}\right)^2\right) - \frac{143}{70} \left(\frac{a_0}{z}\right)^6 \left(1 + \frac{I_1}{I_0} \left(\frac{a_1}{a_0}\right)^8\right) + 0(z^{-8})\right] \quad z > a$$

6

EP 0 167 243 B1

Now choose $I_1/I_0$ $(a_1/a_0)^2 = -1$ so that the dipole term is zero. The expressions become

$$B_z = -\frac{15}{16}\mu_0\frac{I_0}{a_0}\left[\left(1-\left(\frac{a_0}{a_1}\right)^3\right) - \frac{143}{70}\left(\frac{z}{a_0}\right)^6\left(1-\left(\frac{a_0}{a_1}\right)^9\right) + 0(z^8)\right]\quad z<a.$$

$$B_z = \frac{15}{16}\cdot\frac{143}{70}\mu_0\frac{I_0}{a_0}\left(\frac{a_0}{z}\right)^9\left[\left(\left(\frac{a_1}{a_0}\right)^6 - 1\right) + 0(z^{-2})\right]\quad z>a.$$

It is seen that the inner field is reduced by the factor $1-(a_0/a_1)^3$ from its value without the field due to the outer sphere. However, the field outside now changes very rapidly, as intended.

As a specific example, assume that the outer coils are on a radius of 125 cm and the inner coils are on a radius of 80 cm. The inner field is then approximately 74% of its uncompensated value. However, if the inner field is maintained at a value of 1.5 Tesla, the external field has dropped to 5 gauss at a distance of 2.8 meters. If the dipole term were not cancelled, this distance would have to be 11.5 meters. The equations also show that the uniformity of the field in the central region is excellent, even though the field falls off so rapidly outside. In the example, the field varies by only a part in $10^7$ over a volume 9 cm in diameter or by a part in $10^6$ over a volume of 13 cm in diameter.

The excellent field uniformity of the magnets will not be preserved in the presence of nearby ferromagnetic material or other sources of magnetic fields. This problem is, of course, not unique to the particular winding geometry discussed here. It is typically solved through the use of correction windings to null the offending fields and gradients. It is also necessary that the external sources be constant in time and position, and that they not be too close. Since many such sources are not easily controlled (cars, trucks, elevators, tool carts, etc.), it is frequently necessary to surround the room containing the uniform field magnet with ferromagnetic shielding. In the normal winding configuration this also reduces the field outside the shield to allowed levels.

The problem with the use of the ferromagnetic shield with conventional magnets is that the weight of the material required can be enormous. The self shielding magnets described here require much less material. The following simple model shows that the required material differs by a factor of 500 or more between the two magnets.

Assume that the field outside some magnet falls off as $1/r^n$. The field can then be written as B $B_s(a_s/r)^n$, where $B_s$ is the average field over the surface of a sphere of radius $d_s$ outside the magnet. The flux which has to return outside the radius $a_s$ is

$$\phi_n \cong \oint B\cdot dA = \frac{2\pi}{n-2}B_n a_n^2 (n>2).$$

This flux must be returned inside the shielding material, and through the requirement that it not be saturated sets its minimum thickness.

To illustrate the requirements, compare the 6 coil self shielded magnet discussed earlier with the 3 coil conventional magnet. Assume a spherical shield with 3 meter radius and assume that the central field is 1.5 Telsa.

Interestingly, in the model being used, the weight of the shield for the conventional magnet is independent of the shield radius. The field at the shield radius will be approximately 3.8 gauss for one magnet and 280 gauss for the other, leading to a return flux of 31 gauss meter$^2$ and 16 kilogauss m$^2$ respectively. If the shielding material is assumed to saturate at 10 kg, then 31 cm$^2$, or 1.6 m$^2$ is required, for a thickness of .16 mm or 8.5 cm. If this is translated into the weight of an iron sphere of 3 meter radius and the indicated thickness, assuming a density of 7.5 gms/cm$^3$, the conventional magnet requires 80 tons, while the self shielding magnet requires only 300 lbs.

In addition to the weight of the shield, the forces between the shield and magnet need to be taken into account. These forces are proportional to the product of the magnitude of the field and the field gradient at the location of the shield. Although the gradient of the self shielded magnet's fields is larger than that of the conventional magnet, the magnitude of the fields is such that the forces in the self shielded case are only 1/2000 those of the conventional case, at the 3 meter point.

The calculations presented are based upon idealized coils consisting of filamentary current loops as approximations in some sense to an equally idealized current sheet on the surface of a sphere. Real systems will have to be made with coils of finite dimensions, and will require some modifications in some of the details of the preceding equations. Enough work has been done on numerical calculations using dimensions of realistic coils to show that the advantage of these ideas can be realized in practical designs for central fields of at least 2 Tesla. Further, in the described embodiment the coils are assumed to be on a spherical surface. However, the coils could be arranged on any generally speroidal surface including an

7

approximation thereof, the approximation being dependent on a number of factors including coil cross-section.

This is illustrated in the section views of several sets of internal coils having different coil cross-sections shown in Figure 5.

The coils 50 form a first set in which the aspect ratio (height-to-width, h/w) is 1; the coils 52 form a second set in which the aspect ratio is 0.1; and the coils 54 form a set in which the aspect ratio is 0.03. The placement of the coils can be compared with the placement of ideal filament coils 56. The coil sets 50—54 were generated by computer simulation of seal coils based on the integration of the expression for magnetic field with respect to i for the real coil configurations and assuming a uniform current density in the coils.

The discussion of the technique for cancellation of the external fields has concentrated on examples in which the desired field in the interior region of the coils is uniform. It should be clear, however, that the technique is perfectly adaptable to the production of rather arbitrary field configurations within the central region, while retaining the property of very low external fields. An example is the production of the uniform gradient fields required in NMR imaging. These fields are typically pulsed and have to be superimposed on the large uniform field. The induction of eddy currents in nearby conductors can be a serious problem. The use of the external field cancelling method being presented here can allow the gradient fields to be produced with greatly reduced problems due to the eddy currents.

## Claims

1. An NMR magnetic structure comprising an opening (12) leading to a volume (10) for receiving a patient; a first set of superconducting coils (20, 22, 24) provided about said volume (10) and energizable to establish a field with suppressed lower order derivatives of flux through said volume (10) and a dipole with higher order magnetic moments outside of said first set of coils (20, 22, 24); and a second set of superconducting coils (26, 28, 30) provided about said first set of coils (20, 22, 24) and energizable for producing a magnetic field which opposes said dipole of said first set of coils (20, 22, 24) while not substantially affecting the uniformity of said field through said volume (10), characterised in that said first set of coils (20, 22, 24) and said second set of coils (26, 28, 30) are arranged on generally spheroidal surfaces about said opening (12), and in that said first and second sets of coils (20, 22, 24 and 26, 28, 30) are configured and energized to suppress lower orders of derivatives of flux within said first and second sets of coils and to suppress corresponding multipole moments of the magnetic flux outside of said second set of coils (26, 28, 30), and to suppress multipole moments outside of the structure.

2. A method of shielding a magnetic structure for use in NMR imaging characterised by the steps of providing a first set of coils (20, 22, 24) which define a first spheroidal surface, energising each of said first set of coils to establish a uniform magnetic field within said first spheroidal surface and a dipole outside of said first spheroidal surface, each coil of said first set of coils being independently energized to suppress lower order derivatives of flux with respect to position within said uniform magnetic field and simultaneously suppress lower order magnetic moments outside of said first spheroidal surface, providing a second set of coils (26, 28, 30) which define a second spheroidal surface concentric with and outside of said first spheroidal surface, and energizing each of said second set of coils to establish a magnetic field outside of said second spheroidal surface which offsets said dipole while not significantly affecting the uniformity of said magnetic field within said first spheroidal surface.

## Patentansprüche

1. Magnetanordnung für die magnetische Kernresonanz, mit einer zu einem Volumen (10) zur Aufnahme eines Patienten führenden Öffnung (12), einer ersten Gruppe rings um das Volumen (10) angeordneter supraleitender Spulen (20, 22, 24), die zur Bildung eines Feldes mit unterdrückten Ableitungen des Flusses niedrigerer Ordnung durch das Volumen (10) und eines Dipols mit Magnetmomenten höherer Ordnung außerhalb der ersten Gruppe von Spulen (20, 22, 24) erregbar sind, und einer zweiten Gruppe rings um die erste Gruppe von Spulen (20, 22, 24) angeordneter supraleitender Spulen (26, 28, 30), die zur Erzeugung eines Magnetfeldes erregbar sind, das dem Dipol der ersten Gruppe von Spulen (20, 22, 24) entgegengesetzt ist, ohne die Gleichmäßigkeit des Feldes durch das Volumen (10) wesentlich zu beeinträchtigen, dadurch gekennzeichnet, daß die erste Gruppe von Spulen (20, 22, 24) und die zweite Gruppe von Spulen (26, 28, 30) auf insgesamt kugelförmigen Oberflächen um die Öffnung (12) angeordnet sind, und daß die erste und zweite Gruppe von Spulen (20, 22, 24 und 26, 28, 30) so aufgebaut sind und erregt werden, daß Ableitungen des Flusses niedriger Ordnungen innerhalb der ersten und zweiten Gruppe von Spulen, entsprechende Multipolmomente des Magnetflusses außerhalb der zweiten Gruppe von Spulen (26, 28, 30) und Multipolmomente außerhalb der Anordnung unterdrückt werden.

2. Verfahren zur Abschirmung einer Magnetanordnung zur Anwendung bei der magnetischen Kernresonanz - Darstellung, dadurch gekennzeichnet, daß eine erste Gruppe von Spulen (20, 22, 24) vorgesehen wird, die eine erste Kugeloberfläche definieren, daß jede der ersten Gruppe von Spulen so erregt wird, daß innerhalb der ersten Kugeloberfläche ein gleichmäßiges Magnetfeld und außerhalb der ersten Kugeloberfläche ein Dipol gebildet wird, wobei jede Spule der ersten Spulengruppe unabhängig erregt wird, so daß Ableitungen des Flusses niedrigerer Ordnung gegenüber der Stellung innerhalb des gleichförmigen Magnetfeldes und gleichzeitig magnetische Momente niedrigerer Ordnung außerhalb der ersten Kugeloberfläche unterdrückt werden, daß eine zweite Gruppe von Spulen (26, 28, 30) vorgesehen wird, die eine zweite Kugeloberfläche definieren, die konzentrisch zu und außerhalb der ersten Kugeloberfläche liegt, und daß jede der zweiten Gruppe von Spulen so erregt wird, daß ein Magnetfeld außerhalb der zweiten Kugeloberfläche gebildet wird, das den Dipol aufhebt, ohne die Gleichmäßigkeit des Magnetfeldes innerhalb der ersten Kugeloberfläche wesentlich zu beeinträchtigen.

**Revendications**

1. Structure magnétique RMN présentant une ouverture (12) menant à un volume (10) destiné à recevoir un patient; un premier jeu d'enroulements supraconducteurs (20, 22, 24) disposé autour dudit volume (10) et pouvant être excité pour établir dans ledit volume (10) un champ dont les dérivés de flux d'ordre inférieur sont supprimés et un dipôle ayant des moments magnétiques d'ordre supérieur à l'extérieur dudit premier jeu d'enroulements (20, 22, 24); et un second jeu d'enroulements supraconducteurs (26, 28, 30) disposé autour dudit premier jeu d'enroulements (20, 22, 24) et pouvant être excité pour produire un champ magnétique qui s'oppose audit dipôle dudit premier jeu d'enroulements (20, 22, 24) sans affecter sensiblement l'uniformité dudit champ dans ledit volume (10), caractérisée en ce que ledit premier jeu d'enroulements (20, 22, 24) et ledit second jeu d'enroulements (26, 28, 30) sont disposés sur des surfaces globalement sphéroïdales autour de ladite ouverture (12), et en ce que lesdits premier et second jeux d'enroulements (20, 22, 24 et 26, 28, 30) sont configurés et excités pour supprimer des ordres inférieurs de dérivés de flux à l'intérieur desdits premier et second jeux d'enroulements et pour supprimer des moments multipolaires correspondants du flux magnétique à l'extérieur dudit second jeu d'enroulements (26, 28, 30), et pour supprimer des moments multipolaires à l'extérieur de la structure.

2. Procédé d'écrannage d'une structure magnétique à utiliser en imagerie RMN, caractérisé par les étapes qui consistent à utiliser un premier jeu d'enroulements (20, 22, 24) qui définissent une première surface sphéroïdale, à exciter chacun des enroulements dudit premier jeu pour établir un champ magnétique uniforme à l'intérieur de ladite première surface sphéroïdale et un dipôle à l'extérieur de ladite première surface sphéroïdale chaque enroulement dudit premier jeu d'enroulements étant excité indépendamment pour supprimer des dérivés d'ordre inférieur du flux par rapport à une position à l'intérieur dudit champ magnétique uniforme et pour supprimer simultanément des moments magnétiques d'ordre inférieur à l'extérieur de ladite première surface sphéroïdale, à utiliser un second jeu d'enroulements (26, 28, 30) qui définissent une seconde surface sphéroïdale concentrique et extérieure à ladite première surface sphéroïdale, et à exciter chacun des enroulements dudit second jeu pour établir un champ magnétique extérieur à ladite seconde surface sphéroïdale, qui compense ledit dipôle sans affecter notablement l'uniformité dudit champ magnétique à l'intérieur de ladite première surface sphéroïdale.

FIG.—1

CRYO REFRIG

FIG.—2

100 GAUSS

5 GAUSS

1 METER

FIG.—3

EP 0 167 243 B1

CONVENTIONAL MAGNET
AND 5 GAUSS CONTOUR

EXTERNAL MULTIPOLE
CORRECTED MAGNET
AND 5 GAUSS CONTOUR

10 METERS

FIG.—4

FIG.—5

4